# EUROPÄISCHE PATENTSCHRIFT

(11) **EP 2 318 473 B1**
(45) Veröffentlichungstag und Bekanntmachung des Hinweises auf die Patenterteilung: **29.05.2013**
(21) Anmeldenummer: 09777707.2
(22) Anmeldetag: 06.08.2009
(51) Int. Cl.: C09K 11/06, H01L 51/00

(54) **FLUORVERBRÜCKTE ASSOZIATE FÜR OPTOELEKTRONISCHE ANWENDUNGEN**
FLUORINE-BRIDGED ASSOCIATIONS FOR OPTOELECTRONIC APPLICATIONS
COMPLEXES À PONTAGE FLUOR DESTINÉS À DES APPLICATIONS OPTOÉLECTRONIQUES

(30) Priorität: 03.09.2008 DE 102008045663
(43) Veröffentlichungstag der Anmeldung: 11.05.2011
(73) Patentinhaber: Merck Patent GmbH, 64293 Darmstadt (DE)
(72) Erfinder: BUCHHOLZ, Herwig, 60599 Frankfurt (DE); HEUN, Susanne, 65812 Bad Soden (DE); EBERLE, Thomas, 76829 Landau (DE)
(86) Internationale Anmeldenummer: PCT/EP2009/005707
(87) Internationale Veröffentlichungsnummer: WO 2010/025802

(56) Entgegenhaltungen:
- EP-A- 1 220 341
- EP-A- 1 492 173

## Beschreibung

Die vorliegende Erfindung betrifft ein fluorverbrücktes Assoziat, bestehend aus einem Oligomer oder Polymer, enthaltend Fluorreste, die an das Oligomer- oder Polymergrundgerüst gebunden sind, wobei in dem Grundgerüst eine Elektronentransport- und/oder Elektroneninjektionseinheit vorliegt und einer Verbindung mit einem Fluorrest, die eine Emittereinheit umfasst, sowie eine optoelektronische Vorrichtung, in der das fluorverbrückte Assoziat eingesetzt wird.

Elektronische Vorrichtungen, die organische, metallorganische und/oder polymere Halbleiter enthalten, werden immer häufiger in kommerziellen Produkten verwendet oder stehen kurz vor der Markteinführung. Als Beispiele seien hier Ladungstransportmaterialien auf organischer Basis (beispielsweise Lochtransporter auf Triarylamin-Basis) in Kopiergeräten und organische oder polymere Leuchtdioden (OLED = Organic Light Emitting Diode oder PLED = Polymeric Light Emitting Diode) in Anzeige- und Displayvorrichtungen genannt. Organische Solarzellen (O-SC), organische Feldeffekt-Transistoren (O-FET), organische Dünnfilm-Transistoren (O-TFT), organische Schaltelemente (O-IC), organische optische Verstärker und organische Laserdioden (O-Laser) sind in einem fortgeschrittenen Entwicklungsstand und können in der Zukunft große Bedeutung erlangen.

Viele dieser elektronischen bzw. optoelektronischen Vorrichtungen weisen unabhängig von dem jeweiligen Verwendungszweck folgenden allgemeinen Schichtaufbau auf, der für die jeweilige Anwendung angepasst werden kann:
(1) Substrat,
(2) Elektrode, die häufig metallisch oder anorganisch ist, aber auch aus organischen bzw. polymeren leitfähigen Materialien aufgebaut sein kann,
(3) gegebenenfalls eine oder mehrere Ladungsinjektionsschicht/en bzw. Zwischenschicht/en zum Ausgleich von Unebenheiten der Elektrode ("planarisation layer"), die häufig aus einem oder mehreren leitfähigen, dotierten Polymer/en ausgebildet ist/sind,
(4) mindestens eine Schicht eines organischen Halbleiters,
(5) gegebenenfalls eine oder mehrere weitere Ladungstransport- bzw. Ladungsinjektions- bzw. Ladungsblockierschicht/en,
(6) Gegenelektrode, bei der die unter (2) genannten Materialien eingesetzt werden,
(7) Verkapselung.

Die vorliegende Erfindung ist insbesondere, aber nicht ausschließlich, auf organische Leuchtdioden (OLED) gerichtet, die bei Verwendung von polymeren Materialien oft auch als polymere Leuchtdioden (PLED) bezeichnet werden. Die vorstehend beschriebene Anordnung stellt den allgemeinen Aufbau einer optoelektronischen Vorrichtung dar, wobei verschiedene Schichten zusammengefasst werden können, so dass im einfachsten Fall eine Anordnung aus zwei Elektroden, zwischen denen sich eine organische Schicht befindet, besteht. Die organische Halbleiter-Schicht erfüllt in diesem Fall alle Funktionen, einschließlich der Emission von Licht. Ein derartiges System wird beispielsweise in der WO 90/13148 A1 auf der Basis von Poly-(p-phenylenen) beschrieben.

Bei den Polymeren für optoelektronische Anwendungen, die in der vorstehend genannten organischen Halbleiter-Schicht verwendet werden können, handelt es sich im Allgemeinen um Polymere mit konjugierter oder teilkonjugierter Hauptkette, wobei das Polymergrundgerüst selbst eine wichtige Rolle bezüglich der optoelektronischen Eigenschaften spielt, um Seitenkettenpolymere, wie z.B. PVK (Poly-N-vinylcarbazol), bei denen die Funktionalität durch eine Transporteinheit realisiert wird, die chemisch mit dem Grundgerüst verbunden ist, oder um neutrale Polymere, die lediglich die Filmbildungseigenschaften bereitstellen (wie es von organischen Lichtempfängern bzw. Photorezeptoren bekannt ist, bei denen Lochtransportmaterialien typischerweise in Polycarbonat gelöst sind). Alle diese Ansätze sind im Prinzip funktionsfähig und werden in der Literatur beschrieben.

Konjugierte Polymere für optoelektronische Anwendungen, wie z.B. Polyfluorene, Polyindenofluorene, Polyphenylene und Polyphenylenvinylene, haben sich für OLED-Anwendungen und organische Photovoltaikanwendungen als geeignet erwiesen. Die Lebensdauer der Vorrichtungen, die aus diesen Polymeren hergestellt sind, hat im Laufe der Jahre stetig zugenommen, wobei jedoch der Fortschritt langsamer war als bei "Evaporated Small Molecule"-Vorrichtungen (SMOLED's). Der Grund dafür ist auf die Tatsache zurückzuführen, dass in einem mehrschichtigen SMOLED erforderliche Funktionalitäten, wie z.B. Lochtransport, Elektronentransport, Rekombination und Emission in jeweilige Schichten getrennt werden können, wohingegen bei dem teilweise oder vollständig konjugierten Polymer alle diese Funktionalitäten in einer Schicht kombiniert sind. Konjugierte Polymere sind gegenwärtig die beste Option von den drei vorstehend genannten Optionen, da insbesondere stabile Elektronentransportmoleküle nicht ohne weiteres verfügbar sind und folglich nicht leicht in eine neutrale Matrix eingemischt werden können. Dieser Transportteil wird üblicherweise von dem Grundgerüst übernommen, ist jedoch offensichtlich nicht so stabil wie in SMOLEDs. Darüber hinaus stehen konjugierte Einheiten miteinander in Verbindung und verschieben deshalb den HOMO-LUMO-Abstand in Richtung niedrigerer Energien, wodurch der verfügbare Farbbereich für konjugierte Polymere begrenzt wird (ein tiefes Blau ist bei einem vollständig konjugierten Polymer kaum möglich). Aufgrund der Problematik bezüglich der Begrenzung der Lebensdauer und des Bandabstands scheinen die anderen zwei Ansätze interessanter zu sein, da sie dem Fall des kleinen Moleküls ähnlicher sind. Das statistische Mischen von Elektronen- und Lochtransportmolekülen in einer Matrix führt jedoch üblicherweise zu Charge-Transfer-Zuständen, die üblicherweise die Elektrolumineszenz quenchen.

Seitenkettenpolymere, wie z.B. PVK, weisen andererseits ein neutrales, PE-artiges Grundgerüst auf und werden deshalb entweder durch radikalische, kationische, anionische oder koordinative Polymerisation hergestellt. Es ist jedoch nicht einfach, diese Verfahren zu steuern, da insbesondere die Toleranz bezüglich radikalischer oder geladener Endgruppen in OLED-Vorrichtungen ziemlich gering ist (ppm-Niveau). Darüber hinaus können sich funktionelle Einheiten recht nahe kommen, da die Polymerisation ein statistischer Vorgang ist, so dass Charge-Transfer-Komplexe oder eine Dimerbildung (wie es von PVK bekannt ist) eine signifikante Hürde bezüglich der Effizienz und der Langlebigkeit darstellen bzw. darstellt.

Organische Elektrolumineszenzvorrichtungen, umfassend eine Anode, eine Kathode und eine polymere Lumineszenzschicht, die zwischen der Anode und der Kathode angeordnet ist, werden in der EP 1220341 A2 offenbart. Die polymere Lumineszenzschicht umfasst dabei ein π-Elektronen konjugiertes Polymer mit einer Kohlenstoff-Fluor-Bindung und ein lumineszierendes Farbstoffmolekül, welches ebenfalls eine Kohlenstoff-Fluor-Bindung aufweisen kann.

Licht-emittierende Vorrichtungen, die in der Lumineszenzschicht mindestens einen Seltene Erden-Metallkomplex, der eine Kohlenstoff-Fluor-Bindung aufweisen kann, und ein Fluor-basiertes Polymer enthalten, werden in der EP 1492173 A2 offenbart.

Im Hinblick auf den vorstehend beschriebenen Stand der Technik bestand die Aufgabe der vorliegenden Erfindung darin, neue optoelektronisch funktionelle Oligomere oder Polymere für optoelektronische Anwendungen, insbesondere für OLED-Anwendungen, die die vorstehend genannten Nachteile bekannter Ansätze nicht aufweisen, sowie eine optoelektronische Vorrichtung, die die neuen, optoelektronisch funktionellen Oligomere oder Polymere enthält, bereitzustellen.

Diese Aufgabe wird erfindungsgemäß durch ein fluorverbrücktes Assoziat nach Anspruch 1 und eine optoelektronische Vorrichtung nach Anspruch 5 gelöst. Vorteilhafte Weiterbildungen und Ausgestaltungen der vorliegenden Erfindung sind in den abhängigen Ansprüchen angegeben.

Erfindungsgemäß wird ein fluorverbrücktes Assoziat bereitgestellt, bestehend aus
- einem Oligomer oder Polymer, enthaltend Fluorreste, die an das Oligomer- oder Polymergrundgerüst gebunden sind, und
- einer Verbindung mit einem Fluorrest, dadurch gekennzeichnet, dass in dem Oligomer- oder Polymergrundgerüst eine Elektronentransport- und/oder Elektroneninjektionseinheit vorliegt, ausgewählt aus substituierten oder unsubstituierten Pyridinen, Pyrimidinen, Pyridazinen, Pyrazinen, Pyrenen, Perylenen, Anthracenen, Benzanthracenen, Oxadiazolen, Chinolinen, Chinoxalinen, Phenazinen, Benzimidazolen, Ketonen, Phosphinoxiden, Sulfoxiden, Triazinen, Triarylboranen und Benzophenonen,
dass das fluorverbrückte Assoziat eine Emittereinheit als Verbindung mit einem Fluorrest umfasst,
dass die Emittereinheit ein Triplett-Emitter ist, der Ru, Os, Rh, Ir, Pd oder Pt enthält und
dass die Fluorreste die allgemeine Formel CₓH_{y}F_{z} haben, wobei x > 0, y ≥ 0 und z ≥ 1 sind und keine, eine oder mehrere CH₂-Gruppen, die auch benachbart sein können, durch O, S, Se, Te, Si(R¹)₂, Ge(R¹)₂, NR¹, PR¹, CO, P(R¹)O ersetzt sein können, wobei R¹ bei jedem Auftreten gleich oder verschieden eine geradkettige, verzweigte oder cyclische Alkyl-, Alkenyl-, Alkinyl-, Aryl-, Arylalkyl-, Arylalkenyl-, Arylalkinyl-, Heteroaryl- oder Heteroalkylgruppe ist, wobei auch ein oder mehrere nicht benachbarte C-Atome der nicht aromatischen Anteile durch O, S, COO, OCO ersetzt sein können, mit der Maßgabe, dass zwei Reste R¹ auch miteinander Ringsysteme bilden können.

Das erfindungsgemäße fluorverbrückte Assoziat enthält ein Oligomer- oder Polymergrundgerüst, an das Fluorreste gebunden sind, die aus den weiter unten genannten Fluorresten ausgewählt sein können. "Grundgerüst" bedeutet im Sinne der vorliegenden Erfindung, dass die Fluorreste sich direkt am Polymer- oder Oligomer-Rückgrat oder in gegebenenfalls vorhandenen Seitenketten des Polymers oder Oligomers befinden können. Ferner enthält das Oligomer- oder Polymergrundgerüst (auch hier gilt die oben genannte Definition), eine Elektronentransport- und/oder Elektroneninjektionseinheit. Beispiele für diese Einheit werden ebenfalls weiter unten beschrieben.

Der Grundgedanke der vorliegenden Erfindung besteht darin, an das Oligomer- oder Polymergrundgerüst Verbindungen mit einem Fluorrest mittels fluorophiler Wechselwirkungen zu binden, so dass ein fluorverbrücktes Assoziat erhalten wird, das zumindest einen Teil der Funktionen oder sogar alle Funktionen, die für eine organische Schicht z.B. in einer OLED erforderlich sind, d.h. Lochtransport- und/oder Lochinjektion, Elektronen-transport- und/oder Elektroneninjektion, und Emission, aufweist. Diese Verbindungen mit einem Fluorrest können erfindungsgemäß aus der Gruppe, bestehend aus einer Emittereinheit ausgewählt sein, wobei Beispiele ebenfalls weiter unten beschrieben werden.

"Eine Emittereinheit" ist gleichbedeutend mit "mehreren Emittereinheiten". Im Allgemeinen umfasst eine Bezeichnung im Singular, wie "ein" oder "eine" oder "einer" usw. in der vorliegenden Erfindung ebenfalls auch eine Mehrzahl davon, solange nichts anderes ausdrücklich erwähnt wird.

Gegenüber dem Stand der Technik ergibt sich durch das fluorverbrückte Assoziat der vorliegenden Erfindung der Vorteil, dass die funktionellen Verbindungen mit optoelektronischen Funktionen an das Oligomer- oder Polymergrundgerüst (oder die Seitenkette) ohne chemische Reaktionen gebunden und an der gewünschten Stelle an dem Oligomer- oder Polymergrundgerüst (oder der Seitenkette) sowie in einem gewünschten Abstand dazu positioniert werden können.

Wechselwirkungen, die die Lebensdauer und die Effizienz einer optoelektronischen Vorrichtung vermindern, die das fluorverbrückte Assoziat der vorliegenden Erfindung enthält, können auf diese Weise vermieden werden.

In einer weiteren Ausführungsform umfasst das Oligomer- oder Polymergrundgerüst eine Elektronentransport- und/oder Elektroneninjektionseinheit und das fluorverbrückte Assoziat eine Emittereinheit als Verbindung mit einem Fluorrest.

Gemäß der vorstehend genannten bevorzugten Ausführungsform lassen sich die Funktionen des fluorverbrückten Assoziats der vorliegenden Erfindung im Hinblick auf den jeweiligen Anwendungszweck maßschneidern.

In einer weiteren bevorzugten Ausführungsform ist das Oligomer oder das Polymer ein nicht-konjugiertes oder teilkonjugiertes Homo- oder Co-Oligomer oder -Polymer.

Konjugierte Oligomere oder Polymere im Sinne der vorliegenden Erfindung sind Oligomere oder Polymere, die in der Hauptkette hauptsächlich sp²-hybridisierte (bzw. auch sp-hybridisierte) Kohlenstoffatome enthalten, die auch durch entsprechende Heteroatome ersetzt sein können. Dies bedeutet im einfachsten Fall das abwechselnde Vorliegen von Doppel- und Einfachbindungen in der Hauptkette. Der Begriff "hauptsächlich" bedeutet, dass natürlich auftretende Defekte, die zu Konjugationsunterbrechungen führen trotzdem unter den Begriff "konjugiertes Oligomer oder Polymer" fallen. Es sind damit jedoch keine Oligomere oder Polymere gemeint, die absichtlich eingefügte größere Mengen an nicht-konjugierten Segmenten enthalten. Des Weiteren wird in der vorliegenden Erfindung ein Polymer bzw. Oligomer ebenfalls als konjugiert bezeichnet, wenn sich in der Hauptkette beispielsweise Arylamineinheiten, Arylphosphineinheiten und/oder Heterocyclen (d. h. Konjugation über N-, O- oder S-Atome) und/oder metallorganische Komplexe (d. h. Konjugation über das Metallatom) befinden.

Hingegen werden Einheiten wie beispielsweise einfache (Thio)Etherbrücken, Esterverknüpfungen, Amid- oder Imidverknüpfungen in der vorliegenden Erfindung als nicht-konjugierte Segmente definiert. Unter einem teilkonjugierten Oligomer oder Polymer im Sinne der vorliegenden Erfindung soll ein Oligomer oder Polymer verstanden werden, das entweder in der Hauptkette längere konjugierte Abschnitte enthält, die durch nicht-konjugierte Abschnitte unterbrochen werden, oder das in den Seitenketten eines in der Hauptkette nicht-konjugierten Polymers längere konjugierte Abschnitte enthält.

Insbesondere ist das Oligomer oder das Polymer gemäß der vorliegenden Erfindung ein konjugiertes Homo- oder Co-Oligomer oder -Polymer, wobei das Co-Oligomer oder -Polymer in einer weiteren bevorzugten Ausführungsform ein statistisches Co-Oligomer oder -Polymer, ein alternierendes Co-Oligomer oder -polymer oder ein Block-Co-Oligomer oder -Polymer ist.

Die Begriffe "statistisch", "alternierend" oder "Block" im Zusammenhang mit Copolymeren sind dem Fachmann bekannt und müssen hier nicht weiter erläutert werden. Durch die Verwendung eines entsprechenden Copolymers bietet sich dem Fachmann die Möglichkeit, die an das Oligomer- oder Polymergrundgerüst gebundenen Fluorreste besonders einfach in der gewünschten Abfolge und in dem gewünschten Abstand anzuordnen, so dass erfindungsgemäß ein fluorverbrücktes Assoziat erhalten wird, in dem die funktionellen Verbindungen mit einem Fluorrest in der gewünschten Abfolge und in dem gewünschten Abstand angeordnet sind.

Erfindungsgemäß enthält das Oligomer vorzugsweise 3 bis 9 Wederholungseinheiten und das Polymer enthält vorzugsweise mehr als 9 (also 10 oder mehr) Wiederholungseinheiten.

Die Fluorreste, die erfindungsgemäß eingesetzt werden können, d.h. die Fluorreste, die an das Oligomer- oder Polymergrundgerüst und die funktionelle Verbindung gebunden sind, haben die allgemeine Formel CₓH_{y}F_{z}, wobei x > 0, y ≥ 0 und z ≥ 1 sind und keine, eine oder mehrere CH₂-Gruppen, die auch benachbart sein können, durch O, S, Se, Te, Si(R¹)₂, Ge(R¹)₂, NR¹, PR¹, CO, P(R¹)O ersetzt sein können, wobei R¹ bei jedem Auftreten gleich oder verschieden eine geradkettige oder verzweigte oder cyclische Alkyl-, Alkenyl-, Alkinyl-, Aryl-, Arylalkyl-, Arylalkenyl-, Arylalkinyl-, Heteroaryl- oder Heteroalkylgruppe ist, wobei auch ein oder mehrere nicht benachbarte C-Atome der nicht aromatischen Anteile durch O, S, CO, COO, OCO ersetzt sein können, mit der Maßgabe, dass zwei Reste R¹ auch miteinander Ringsysteme bilden können.

In einer besonders bevorzugten Ausführungsform der vorliegende Erfindung sind die Fluorreste ausgewählt aus der Gruppe, bestehend aus F, CF₃, C₂F₅, CF₃(CH₂)ₐS, CF₃CF₂S oder (CF₃-(CH₂)ₐ)₂N, wobei a bevorzugt eine ganze Zahl von 0 bis 5 darstellt.

Bei dem fluorverbrückten Assoziat liegt vorzugsweise in dem Oligomer oder Polymer zwischen dem Oligomer- oder Polymergrundgerüst und den Fluorresten ein Spacer Sp vor. Als Spacer Sp können alle Gruppen eingesetzt werden, die dem Fachmann für diesen Zweck bekannt sind. Sp ist vorzugsweise eine lineare oder verzweigte Alkylen-Gruppe mit 1 bis 20 C-Atomen, besonders bevorzugt mit 1 bis 12 C-Atomen, in der eine oder mehrere nicht benachbarte CH₂-Gruppen durch -O-, -S-, -NH-, -N(CH₃)-, -CO-, -O-CO-, -S-CO-, -O-COO-, -CO-S-, -CO-O-, -CH(Halogen)-, -CH(CN)-, -CH=CH- oder -C=C- ersetzt sein können.

Übliche Spacer-Gruppen sind z.B. -(CH₂)ₒ-, -(CH₂CH₂O)ₚ-CH₂CH₂-, -CH₂CH₂-S-CH₂CH₂- oder -CH₂CH₂-NH-CH₂CH₂-, mit o = 2 bis 12 und p = 1 bis 3.

Bevorzugte Spacer-Gruppen sind Ethylen, Propylen, Butylen, Pentylen, Hexylen, Heptylen, Octylen, Nonylen, Decylen, Undecylen, Dodecylen, Octadecylen, Ethylenoxyethylen, Methylenoxybutylen, Ethylenthioethylen, Ethylen-N-methyl-iminoethylen, 1-Methylalkylen, Ethenylen, Propenylen oder Butenylen.

Besonders bevorzugt ist, dass Sp eine Alkyl- oder Alkoxy-Gruppe mit 2 bis 8 C-Atomen bedeutet. Hierbei sind geradkettige Gruppen besonders bevorzugt.

Durch das Vorliegen des Spacers Sp zwischen dem Oligomer- oder Polymergrundgerüst und den Fluorresten kann eine funktionelle Verbindung mit einem Fluorrest, wie z.B. ein Lochleiter, ein Elektronenleiter und ein Emitter, in einem Abstand von dem Oligomer- oder Polymergrundgerüst gehalten werden, so dass eine optimale Leistung der das fluorverbrückte Assoziat enthaltenden optoelektronischen Vorrichtung erhalten wird. Die Einstellung des Spacers auf eine geeignete Länge kann vom Fachmann ohne übermäßiges Experimentieren vorgenommen werden.

Erfindungsgemäß ist der Emitter ein Triplett-Emitter. Insbesondere Triplett-Emitter werden häufig durch konjugierte Bereiche in dem Oligomer- oder Polymergrundgerüst, die den Bandabstand vermindern, gequencht. Durch Positionieren eines Triplett-Emitters an einer Stelle an dem Oligomer- oder Polymergrundgerüst, die ausreichend weit von den konjugierten Bereichen entfernt ist, kann ein solches Quenchen verhindert werden, so dass die Leistung einer entsprechenden optoelektronischen Vorrichtung, in der das fluorverbrückte Assoziat enthalten ist, erfindungsgemäß erhöht werden kann.

Im Folgenden sind spezifische Beispiele für die funktionellen Einheiten (Wiederholungseinheiten) des Oligomers oder Polymers, die in dem erfindungsgemäßen fluorverbrückten Assoziat eingesetzt werden können, angegeben. Ferner sind weitere Wiederholungseinheiten angegeben, die in den Oligomeren oder Polymeren der erfindungsgemäßen fluorverbrückten Assoziate entweder als Oligomer- bzw. Polymergrundgerüsteinheiten eingesetzt werden, oder um diesen weitere spezielle Funktionen zu verleihen.

Bevorzugte Polymere bzw. fluorhaltige Polymere (oder Polymere mit fluorierten oder perfluorierten Seitengruppen) im Sinne der vorliegenden Erfindung sind wie oben bereits ausgeführt konjugierte Polymere oder teilkonjugierte Polymere, die in der Hauptkette sp²-hybridisierte Kohlenstoffatome enthalten, die auch durch entsprechende Heteroatome ersetzt sein können. Des Weiteren wird im Sinne der vorliegenden Erfindung ebenfalls als konjugiert bezeichnet, wenn sich in der Hauptkette beispielsweise Arylamineinheiten und/oder bestimmte Heterocyclen (d. h. Konjugation über N-, O- oder S-Atome) und/oder metallorganische Komplexe (d. h. Konjugation über das Metallatom) befinden. Typische Vertreter konjugierter Polymere, wie sie beispielsweise in PLEDs oder allgemein in O-SCs verwendet werden können, sind Poly-paraphenylenvinylene (PPV), Polyfluorene, Polyspirobifluorene, Polyphenanthrene, Polydihydro-phenanthrene, Polyindenofluorene, Systeme, die im weitesten Sinne auf Poly-p-phenylenen (PPP) basieren, und Derivate dieser Strukturen, insbesondere solche Derivate, die fluorhaltige Gruppen aufweisen.

Besonders bevorzugt sind erfindungsgemäß solche Polymere, die weitere Strukturelemente enthalten und somit als Copolymere zu bezeichnen sind. Hier sei vor allem auch auf die relativ umfangreichen Auflistungen von möglichen Strukturelementen in der WO 02/077060 A1, der WO 2005/014689 A2 und die in diesen Schriften aufgeführten Zitate verwiesen. Diese weiteren Struktureinheiten können beispielsweise aus den im Folgenden beschriebenen Klassen stammen, wobei darauf hingewiesen wird, dass diese Struktureinheiten erfindungsgemäß sowohl als Wiederholungseinheiten eines Polymers (also im Backbone oder der Seitenkette des Polymers oder Oligomers), als auch als erfindungsgemäß eingesetzte Verbindungen mit Fluorresten zu verstehen sind. Im zuletzt genannten Fall sind die Bindungen (meist gestrichelt gezeichnet), die eine Verknüpfung zur nächsten Wiederholungseinheit eines Polymers oder Oligomers darstellen, nicht vorhanden sondern nur ein Fluorrest, bevorzugt wie oben definiert.
- Gruppe 1:: Struktureinheiten, welche das Polymer-Grundgerüst darstellen.
- Gruppe 2:: Struktureinheiten, welche die Lochinjektions- und/oder -transporteigenschaften der Polymere beeinflussen bzw. als Lochinjektions- und/oder -transporteinheit dienen.
- Gruppe 3:: Struktureinheiten, welche die Elektroneninjektions- und/oder -transporteigenschaften der Polymere beeinflussen bzw. als Elektroneninjektions- und/oder -transporteinheit dienen.
- Gruppe 4:: Struktureinheiten, die Kombinationen von Einzeleinheiten der Gruppe 2 und Gruppe 3 aufweisen.
- Gruppe 5:: Struktureinheiten, welche die morphologischen Eigenschaften und/oder die Emissionsfarbe der resultierenden Polymere bzw. des fluorverbrückten Assoziats beeinflussen.
- Gruppe 6:: Struktureinheiten, welche die Emissionscharakteristik insoweit verändern, dass Elektrophosphoreszenz statt Elektrofluoreszenz erhalten werden kann.
- Gruppe 7:: Struktureinheiten, welche den Übergang vom Singulett- zum Triplettzustand verbessern.

Geeignete und bevorzugte Einheiten für die oben genannten Gruppen werden im Folgenden beschrieben, wobei diese bevorzugt die erfindungsgemäß definierten fluorhaltigen Gruppen aufweisen.

### Gruppe 1 - Struktureinheiten, welche das Polymer-Grundgerüst darstellen:

Bevorzugte Einheiten der Gruppe 1 sind insbesondere solche, die aromatische oder carbocyclische Strukturen mit 6 bis 40 C-Atomen beinhalten. Geeignete und bevorzugte Einheiten sind unter anderem Fluoren-Derivate, wie z.B. in der EP 0842208, der WO 99/54385, der WO 00/22027, der WO 00/22026 und der WO 00/46321 offenbart, Indenofluoren-Derivate, ferner Spirobifluoren-Derivate, wie z.B. in der EP 0707020, der EP 0894107 und der WO 03/020790 offenbart, Phenanthren-Derivate oder Dihydrophenanthren-Derivate, wie z.B. in der WO 2005/014689 offenbart. Es ist auch möglich, eine Kombination von zwei oder mehr dieser Monomer-Einheiten zu verwenden, wie z.B. in der WO 02/077060 beschrieben. Bevorzugte Einheiten für das Polymergrundgerüst sind insbesondere Spirobifluoren-, Indenofluoren-, Phenanthren- und Dihydrophenanthren-Derivate.

Besonders bevorzugte Einheiten der Gruppe 1 sind zweibindige Einheiten gemäß den folgenden Formeln, worin die gestrichelten Linien die Verknüpfung zu den benachbarten Einheiten bedeuten: 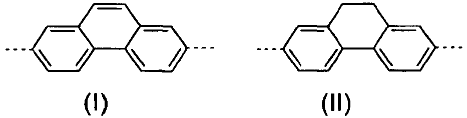 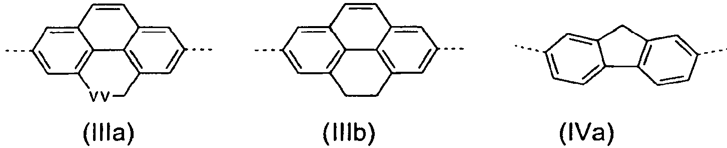 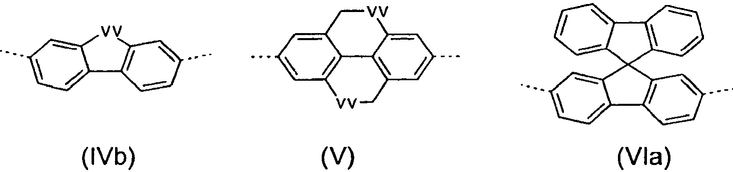 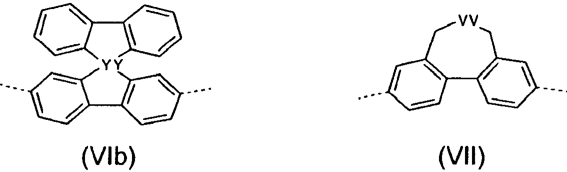 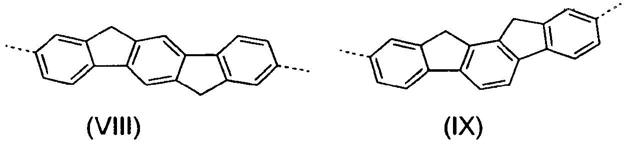 worin die einzelnen Reste folgende Bedeutung besitzen:
- YY: ist Si oder Ge,
- VV: ist O, S oder Se,
und wobei die verschiedenen Formeln an den freien Positionen auch zusätzlich durch einen oder mehrere Substituenten R² substituiert sein können und R² folgendes bedeuten:
R² ist bei jedem Auftreten gleich oder verschieden H, eine geradkettige, verzweigte oder cyclische Alkyl- oder Alkoxykette mit 1 bis 22 C-Atomen, in der auch ein oder mehrere nicht benachbarte C-Atome durch O, S, CO, O-CO, CO-O oder O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R² substituiert sein können, oder F, CN, N(R³)₂ oder B(R³)₂; und
R³ ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, CO, O-CO, CO-O oder O-CO-O ersetzt sein können, wobei auch ein oder mehrere H-Atome durch Fluor ersetzt sein können, oder eine optional substituierte Arylgruppe mit 5 bis 40 C-Atomen, bei der auch ein oder mehrere C-Atome durch O, S oder N ersetzt sein können.

### Gruppe 2 - Struktureinheiten, welche die Lochinjektions- und/oder -transporteigenschaften der Polymere beeinflussen bzw. als Verbindungen mit Fluorresten im Sinne der vorliegenden Erfindung dienen:

Dies sind im Allgemeinen aromatische Amine oder elektronenreiche Heterocyclen, wie z.B. substituierte oder unsubstituierte Triarylamine, Benzidine, Tetraarylen-para-phenylendiamine, Phenothiazine, Phenoxazine, Dihydrophenazine, Thianthrene, Dibenzo-p-dioxine, Phenoxathiine, Carbazole, Azulene, Thiophene, Pyrrole, Furane und weitere O, S oder N-haltige Heterocyclen mit hoch liegendem HOMO (HOMO = höchst liegendes besetztes Molekülorbital). Es kommen hier aber auch Triarylphosphine in Frage, wie z.B. in der WO 2005/017065 A1 beschrieben.

Besonders bevorzugte Einheiten der Gruppe 2 sind zweibindige Einheiten gemäß den folgenden Formeln, worin, für den Fall, dass diese Einheiten Bestandteil eines Oligomers oder Polymers sind, die gestrichelten Linien die Verknüpfung zu den benachbarten Einheiten bedeuten: 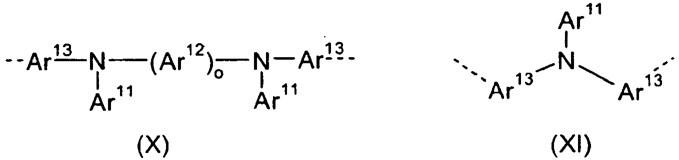 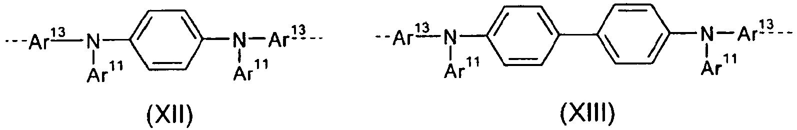 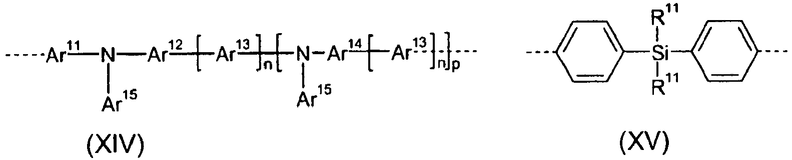 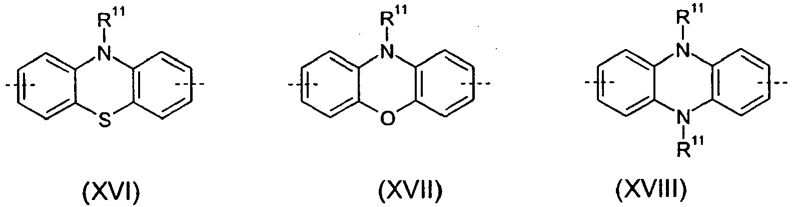 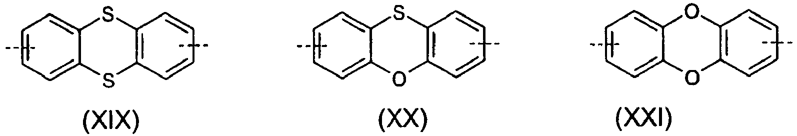 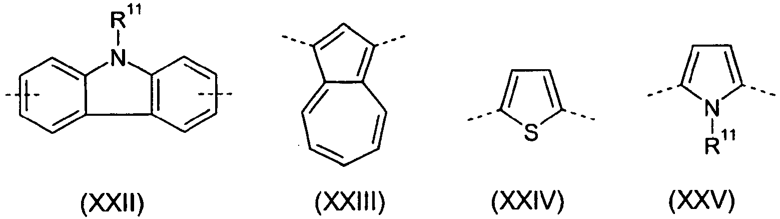 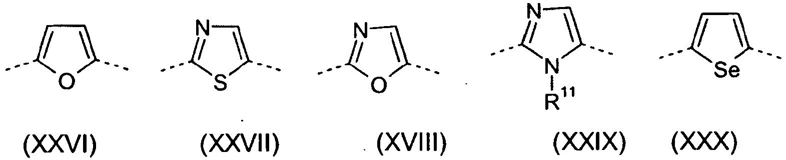 wobei R¹¹ eine der oben für R² angegebenen Bedeutungen besitzt, die verschiedenen Formeln an den freien Positionen auch zusätzlich durch einen oder mehrere Substituenten R¹¹ substituiert sein können und die Symbole und Indices folgendes bedeuten:
n ist gleich oder verschieden bei jedem Auftreten 0, 1 oder 2,
p ist gleich oder verschieden bei jedem Auftreten 0, 1 oder 2, vorzugsweise 0 oder 1,
o ist gleich oder verschieden bei jedem Auftreten 1, 2 oder 3, vorzugsweise 1 oder 2,
Ar¹¹, Ar¹³ sind bei jedem Auftreten gleich oder verschieden ein aromatisches oder heteroaromatisches Ringsystem mit 2 bis 40 C-Atomen, welches durch R¹¹ ein- oder mehrfach substituiert oder auch unsubstituiert sein kann; die möglichen Substituenten R¹¹ können dabei potentiell an jeder freien Position sitzen,
Ar¹², Ar¹⁴ sind bei jedem Auftreten gleich oder verschieden Ar¹¹, Ar¹³ oder eine substituierte oder unsubstituierte Stilbenylen- bzw. Tolanyleneinheit,
Ar¹⁵ ist gleich oder verschieden bei jedem Auftreten entweder ein System gemäß Ar¹¹ oder ein aromatisches oder heteroaromatisches Ringsystem mit 9 bis 40 aromatischen Atomen (C- oder Heteroatome), welches durch R¹¹ ein- oder mehrfach substituiert oder unsubstituiert sein kann und welches aus mindestens zwei kondensierten Ringen besteht; die möglichen Substituenten R¹¹ können dabei potentiell an jeder freien Position sitzen.

### Gruppe 3 - Struktureinheiten, welche die Elektroneninjektions- und/oder -transporteigenschaften der Polymere beeinflussen, bzw. Verbindungen mit Fluorresten im Sinne der vorliegenden Erfindung, die diese Aufgabe erfüllen:

Dies sind im Allgemeinen elektronenarme Aromaten oder Heterocyclen, wie z.B. substituierte oder unsubstituierte Pyridine, Pyrimidine, Pyridazine, Pyrazine, Pyrene, Perylene, Anthracene, Benzanthracene, Oxadiazole, Chinoline, Chinoxaline, Phenazine, Benzimidazole, Ketone, Phosphinoxide, Sulfoxide oder Triazine, aber auch Verbindungen wie Triarylborane und weitere O, S oder N-haltige Heterocyclen mit niedrig liegendem LUMO (LUMO = niedrigstes unbesetztes Molekülorbital), sowie Benzophenone und deren Derivate, wie z.B. in der WO 05/040302 offenbart.

Besonders bevorzugte Einheiten der Gruppe 3 sind zweibindige Einheiten gemäß den folgenden Formeln, worin, für den Fall, dass diese Einheiten Bestandteil eines Oligomers oder Polymers sind, die gestrichelten Linien die Verknüpfung zu den benachbarten Einheiten bedeuten: 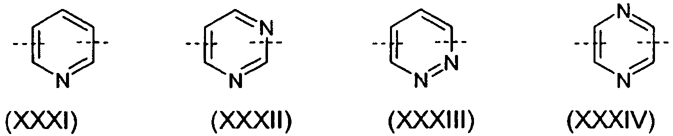 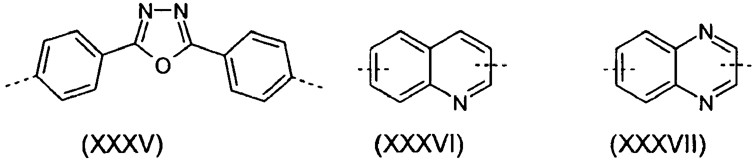 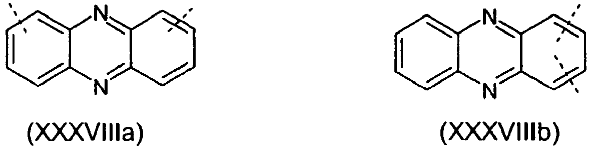 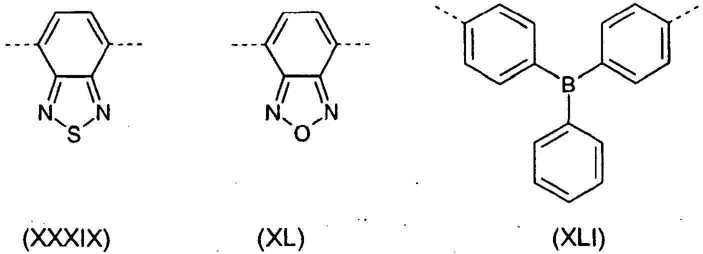 wobei die verschiedenen Formeln an den freien Positionen durch einen oder mehrere Substituenten R¹¹ wie oben definiert substituiert sein können.

### Gruppe 4 - Struktureinheiten, die Kombinationen von Einzeleinheiten der Gruppe 2 und Gruppe 3 aufweisen:

Es ist auch möglich, dass die Polymere, bzw. das erfindungsgemäße fluorverbrückte Assoziat, Struktureinheiten enthalten, in denen Strukturen, welche die Lochmobilität und welche die Elektronenmobilität erhöhen, direkt aneinander gebunden sind oder beides können. Allerdings verschieben einige dieser Einheiten die Emissionsfarbe ins Gelbe oder Rote. Ihre Verwendung in der erfindungsgemäßen optoelektronischen Vorrichtung zur Erzeugung blauer oder grüner Emission ist deshalb weniger bevorzugt.

Falls solche Einheiten der Gruppe 4 in den Polymeren enthalten sind, sind sie vorzugsweise ausgewählt aus zweibindigen Einheiten gemäß den folgenden Formeln, worin, für den Fall, dass diese Einheiten Bestandteil eines Oligomers oder Polymers sind, die gestrichelten Linien die Verknüpfung zu den benachbarten Einheiten bedeuten: 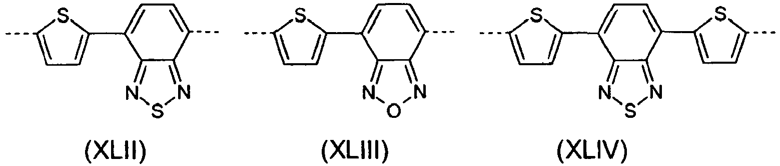 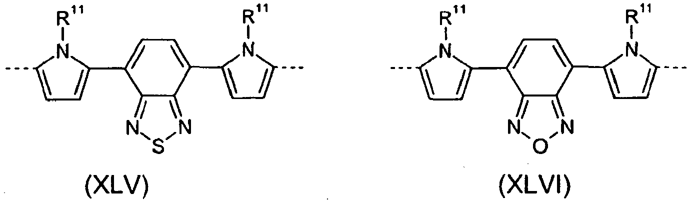 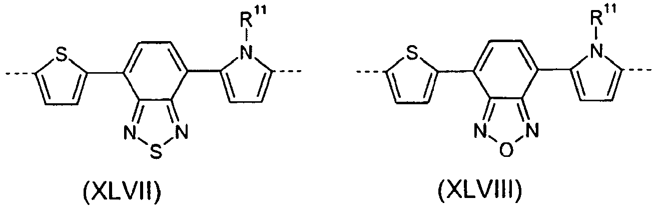 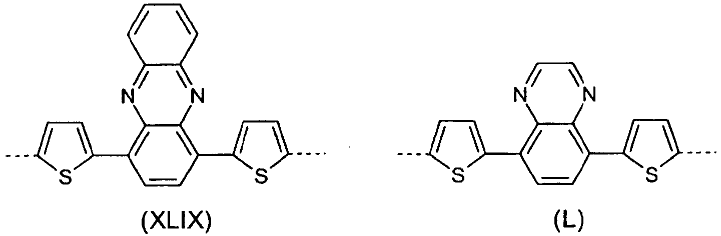 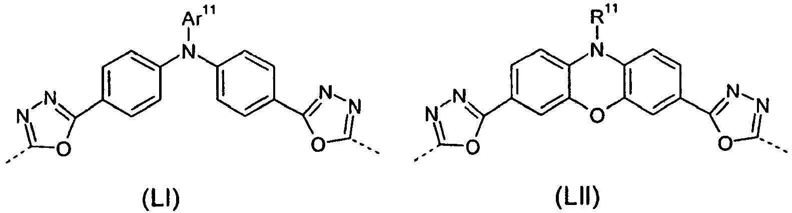 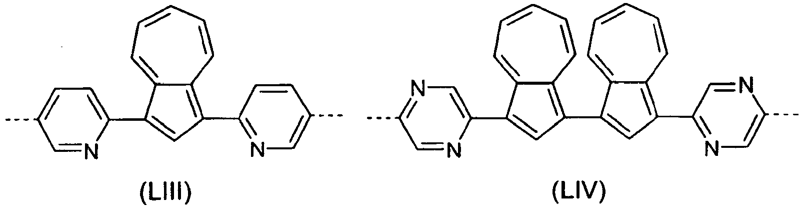 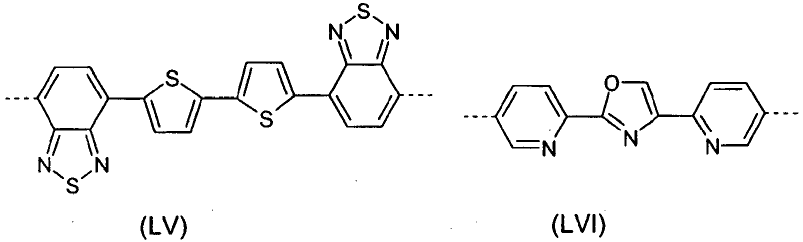 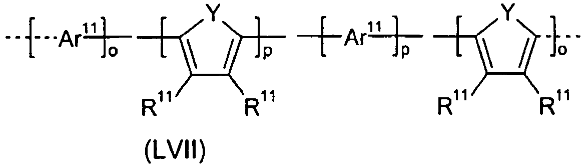 wobei die verschiedenen Formeln an den freien Positionen durch einen oder mehrere Substituenten R¹¹ substituiert sein können, die Symbole R¹¹, Ar¹¹, p und o die oben genannte Bedeutung besitzen und Y bei jedem Auftreten gleich oder verschieden O, S, Se, N, P, Si oder Ge ist.

### Gruppe 5 - Struktureinheiten, welche die morphologischen Eigenschaften und/oder die Emissionsfarbe der resultierenden Polymere beeinflussen bzw. Verbindungen mit Fluorresten im Sinne der vorliegenden Erfindung, die diese Aufgabe erfüllen:

Dies sind neben den oben genannten Einheiten solche, die mindestens noch eine weitere aromatische oder eine andere konjugierte Struktur aufweisen, welche nicht unter die o. g. Gruppen fällt, d. h. die die Ladungsträgermobilität nur wenig beeinflusst, die keine metallorganischen Komplexe sind oder die keinen Einfluss auf den Singulett-Triplett-Übergang haben. Derartige Strukturelemente können die morphologischen Eigenschaften, aber auch die Emissionsfarbe der resultierenden Polymere oder des fluorverbrückten Assoziats beeinflussen. Je nach Einheit können sie daher auch als Emitter eingesetzt werden. Bevorzugt sind dabei substituierte oder unsubstituierte aromatische Strukturen mit 6 bis 40 C-Atomen oder auch Tolan-, Stilben- oder Bisstyrylarylenderivate, die jeweils mit einem oder mehreren Resten R¹¹ substituiert sein können. Besonders bevorzugt ist dabei der Einbau von 1,4-Phenylen-, 1,4-Naphthylen-, 1,4- oder 9,10-Anthrylen-, 1,6-, 2,7- oder 4,9-Pyrenylen-, 3,9- oder 3,10-Perylenylen-, 4,4'-Biphenylylen-, 4,4"-Terphenylylen-, 4,4'-Bi-1,1'-naphthylylen-, 4,4'-Tolanylen-, 4,4'-Stilbenylen- oder 4,4"-Bisstyrylarylenderivaten.

Ganz besonders bevorzugt sind substituierte oder unsubstituierte Strukturen gemäß den folgenden Formeln, worin, für den Fall, dass diese Einheiten Bestandteil eines Oligomers oder Polymers sind, die gestrichelten Linien den Übergang zu den nächsten Wiederholungseinheiten bedeuten: 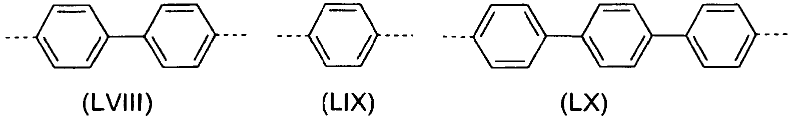 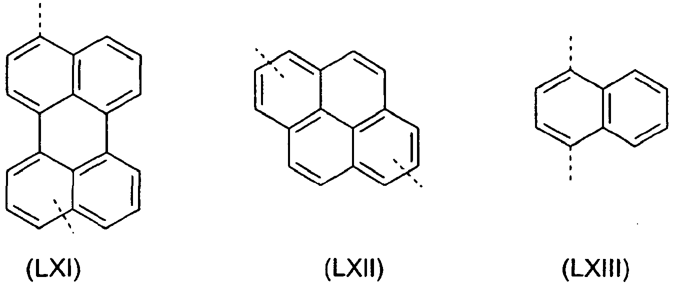 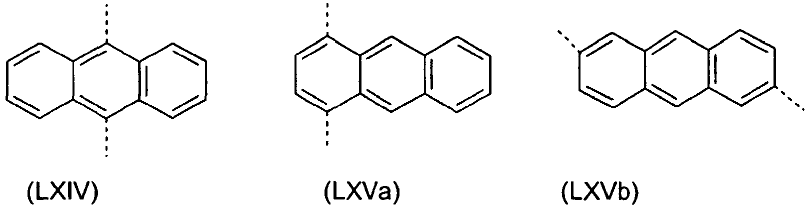 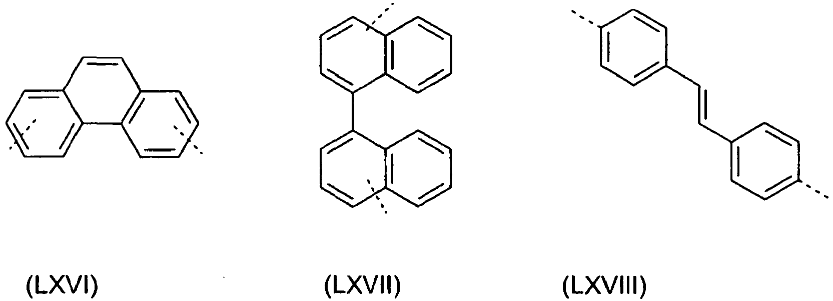 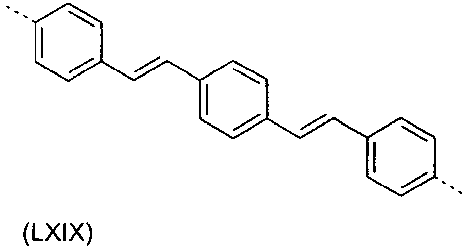 wobei die verschiedenen Formeln an den freien Positionen durch einen oder mehrere Substituenten R¹¹ wie oben definiert substituiert sein können.

Als blau emittierende Einheiten kommen typischerweise Einheiten in Frage, die im Allgemeinen als Oligomer- oder Polymergrundgerüst verwendet werden oder solche, die als blaue Emitter, beispielsweise als erfindungsgemäße fluorierte Verbindung, verwendet werden. Dies sind im Allgemeinen solche, die mindestens eine aromatische oder andere konjugierte Struktur aufweisen, aber die Emissionsfarbe nicht ins Grüne oder ins Rote verschieben.

Bevorzugt sind aromatische Strukturen mit 4 bis 40 C-Atomen, aber auch Stilben- und Tolan-Derivate und gewisse Bis(styryl)arylen-Derivate. Dies sind beispielsweise folgende Strukturelemente, die substituiert oder unsubstituiert sein können: 1,4-Phenylen-, 1,4-Naphthylen-, 1,4- oder 9,10-Anthracenylen-, 2,7- oder 3,6-Phenanthrenylen-, 4,4'-Biphenylylen-, 4,4"-Terphenylylen-, 4,4'-Bi-1,1'-naphthylylen-, 4,4'-Stilbenderivate, 9,10-Dihydropyrenderivate, 4,5,9,10-Tetrahydropyrenderivate (z. B. gemäß EP-A-699699), Fluorenderivate (z. B. gemäß EP-A-0 842 208, WO 99/54385, WO 00/22027, WO 00/22026, WO 00/46321), Spirobifluorenderivate (z. B. gemäß EP-A-0 707 020, EP-A-0 894 107, WO 03/020790, WO 02/077060), 5,7-Dihydrodibenzoxepinderivate, cis- und trans-Indenofluorenderivate (z. B. gemäß GB 0226010 und EP 03014042) und 9,10-Dihydrophenanthrenderivate (z. B. gemäß DE 10337346). Neben diesen Klassen kommen hier beispielsweise auch die sogenannten Leiter-PPPs ("Ladder-PPPs" = LPPP) (z. B. gemäß WO 92/18552), aber auch Ansa-Strukturen enthaltende PPPs (z. B. gemäß EP-A-690086) in Frage. Auch Bis(styryl)arylen-Derivate, die nicht elektronenreich sind, können hierfür verwendet werden.

Es kann auch bevorzugt sein, wenn mehr als eine solche blau emittierende Struktureinheit in einem Oligomer oder Polymer oder einem erfindungsgemäßen fluorverbrückten Assoziat verwendet wird.

Falls das Oligomer oder Polymer oder fluorverbrückte Assoziat grün emittierende Struktureinheiten enthält, kommen hierfür vorzugsweise Struktureinheiten in Frage, welche mindestens eine aromatische oder sonstige konjugierte Struktur aufweisen und die Emissionsfarbe ins Grüne verschieben. Bevorzugte Strukturen für grün emittierende Einheiten sind ausgesucht aus den Gruppen der elektronenreichen Bis-styrylarylene und Derivate dieser Strukturen.

Weitere bevorzugte grün emittierende Struktureinheiten sind ausgewählt aus den Gruppen der Benzothiadiazole und entsprechender Sauerstoffderivate, der Chinoxaline, der Phenothiazine, der Phenoxazine, der Dihydrophenazine, der Bis(thiophenyl)arylene, der Oligo(thiophenylene) und der Phenazine. Dabei ist es auch zulässig, dass statt einer grün emittierenden Struktureinheit mehrere verschiedene solcher Einheiten verwendet werden, wobei dann der Gesamtanteil der grün emittierenden Einheiten maximal 20 mol%, vorzugsweise maximal 10 mol% und besonders bevorzugt maximal 3 mol% beträgt.

Als rot emittierende Struktureinheiten kommen bevorzugt Einheiten in Frage, die mindestens eine aromatische oder sonstige konjugierte Struktur aufweisen und die Emissionsfarbe ins Rote verschieben. Bevorzugte Strukturen für rot emittierende Einheiten sind solche, in denen elektronenreiche Einheiten, wie beispielsweise Thiophen, mit grün emittierenden elektronenarmen Einheiten, wie beispielsweise Chinoxalin oder Benzothiadiazol, kombiniert sind. Weitere bevorzugte rot emittierende Einheiten sind Systeme aus mindestens vier kondensierten aromatischen Einheiten, wie beispielsweise Rubrene, Pentacene oder Perylene, die bevorzugt substituiert sind, oder bevorzugt konjugierte Push-Pull-Systeme (Systeme, die mit Donor- und Akzeptorsubstituenten substituiert sind) oder Systeme wie Squarine oder Chinacridone, die bevorzugt substituiert sind. Dabei ist es auch zulässig, dass statt einer rot emittierenden Einheit mehrere solcher Einheiten verwendet werden, wobei dann der Gesamtanteil der rot emittierenden Einheiten maximal 10 mol%, vorzugsweise maximal 5 mol% und besonders bevorzugt maximal 1 mol% beträgt.

Als blau, grün und rot emittierende Struktureinheiten kommen prinzipiell auch Einheiten in Frage, die aus dem Triplett-Zustand Licht emittieren, also Elektrophosphoreszenz statt Elektrofluoreszenz zeigen, was häufig eine Steigerung der Energieeffizienz bewirkt. Diese Einheiten werden im Folgenden als Triplett-Emitter bezeichnet. Die Verwendung derartiger Metallkomplexe in niedermolekularen OLEDs ist beispielsweise in M. A. Baldo et al. (Appl. Phys. Lett. 1999, 75, 4-6) beschrieben.
• Hierfür eignen sich zunächst Verbindungen, die Schweratome, d. h. Atome aus dem Periodensystem der Elemente mit einer Ordnungszahl von mehr als 36, enthalten.
• Besonders geeignet hierfür sind Verbindungen, die d- und f-Übergangsmetalle beinhalten, die die o. g. Bedingung erfüllen. Ganz besonders bevorzugt sind hier entsprechende Struktureinheiten, welche Elemente der Gruppe 8 bis 10 (d.h. Ru, Os, Rh, Ir, Pd, Pt) enthalten.
• Als Struktureinheiten für die erfindungsgemäßen Polymeren kommen z.B. verschiedene Komplexe in Frage, welche beispielsweise in der WO 02/068435, DE 10116962 A1, EP 1239526 und der DE 10238903 A1 beschrieben sind.

Entsprechende Verbindungen werden in der WO 02/068435 beschrieben.

Die Farben der Komplexe werden dabei in erster Linie vom verwendeten Metall, von der genauen Ligandenstruktur und von den Substituenten am Liganden bestimmt. Es sind sowohl grün als auch rot emittierende Komplexe bekannt. So emittiert beispielsweise ein unsubstituiertes Tris(phenylpyridyl)-iridium(III) grünes Licht, während elektronenschiebende Substituenten in para-Stellung zum koordinierenden Kohlenstoffatom (z. B. Diarylamino-Substituenten) die Emission ins Orange-Rote verschieben. Weiterhin sind Derivate dieses Komplexes mit variierter Ligandenstruktur bekannt, die direkt (ohne weitere Substitutionen) zu orange oder tiefroter Emission führen. Beispiele für solche Liganden sind 2-Phenylisochinolin, 2-Benzothiophenylpyridin oder 2-Naphthylpyridin.

Blau emittierende Komplexe werden beispielsweise erhalten, indem der Tris(phenyl-pyridyl)-iridium(III)-Grundkörper mit elektronenziehenden Substituenten wie beispielsweise mehreren Fluor- und/oder Cyanogruppen substituiert wird.

Die vorstehend beschriebenen Struktureinheiten werden so mit den Fluorresten gemäß der vorliegenden Erfindung substituiert, dass das gewünschte fluorverbrückte Assoziat erhalten werden kann. Die Synthesetechniken zur Herstellung solcher, mit Fluorresten substituierter Struktureinheiten sind dem einschlägigen Fachmann bekannt.

Im Folgenden sind spezifische Beispiele für die funktionellen Verbindungen mit einem Fluorrest, die in dem erfindungsgemäßen fluorverbrückten Assoziat eingesetzt werden können, angegeben.

Bevorzugte fluoreszierende Emitter als Verbindungen mit mindestens einem Fluorrest der vorliegenden Erfindung sind ausgewählt aus der Klasse der Monostyrylamine, der Distyrylamine, der Tristyrylamine, der Tetrastyrylamine und der Arylamine, die jeweils mit mindestens einem Fluorrest substituiert sind. Unter einem Monostyrylamin wird eine Verbindung verstanden, die eine Styrylgruppe und mindestens ein Amin enthält, das bevorzugt aromatisch ist. Unter einem Distyrylamin wird eine Verbindung verstanden, die zwei Styrylgruppen und mindestens ein Amin enthält, das bevorzugt aromatisch ist. Unter einem Tristyrylamin wird eine Verbindung verstanden, die drei Styrylgruppen und mindestens ein Amin enthält, das bevorzugt aromatisch ist. Unter einem Tetrastyrylamin wird eine Verbindung verstanden, die vier Styrylgruppen und mindestens ein Amin enthält, das bevorzugt aromatisch ist. Unter einem Arylamin bzw. einem aromatischen Amin im Sinne der vorliegenden Erfindung wird eine Verbindung verstanden, die drei aromatische oder heteroaromatische Ringsysteme direkt an den Stickstoff gebunden enthält, davon bevorzugt mindestens ein kondensiertes Ringsystem mit mindestens 14 aromatischen Ringatomen. Die Styrylgruppen sind besonders bevorzugt Stilbene, die auch an der Doppelbindung oder an den Aromaten weiter substituiert sein können. Beispiele für derartige Verbindungen sind substituierte oder unsubstituierte Tristilbenamine oder weitere Verbindungen, die beispielsweise in der WO 06/000388, der WO 06/058737, der WO 06/000389, der DE 102005058543 A1 und der DE 102006015183 A1 beschrieben sind. Weiterhin sind Verbindungen gemäß der WO 06/122630 und gemäß der DE 102006025846 A1 als Emitter bevorzugt.

Eine phosphoreszierende Emitterverbindung ist vorzugsweise ausgewählt aus der Klasse der Metallkomplexe, enthaltend mindestens ein Element der Ordnungszahl größer 20, vorzugsweise größer 36 und kleiner 84, besonders bevorzugt größer 56 und kleiner 80. Vorzugsweise werden Metallkomplexe verwendet, die Kupfer, Molybdän, Wolfram, Rhenium, Ruthenium, Osmium, Rhodium, Iridium, Palladium, Platin, Silber, Gold oder Europium enthalten, insbesondere Iridium. Generell eignen sich hierfür phosphoreszierende Materialien, wie sie gemäß dem Stand der Technik verwendet werden.

Gruppe 6 - Struktureinheiten, welche die Emissionscharakteristik insoweit verändern, dass Elektrophosphoreszenz statt Elektrofluoreszenz erhalten werden kann bzw. Verbindungen mit Fluorresten im Sinne der vorliegenden Erfindung, die diese Aufgabe erfüllen:
Dies sind insbesondere solche Struktureinheiten, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Besonders geeignet sind Verbindungen, welche d- oder f-Übergangsmetalle beinhalten, die die o.g. Bedingung erfüllen. Ganz besonders bevorzugt sind hier entsprechende Struktureinheiten, welche Elemente der Gruppe 8 bis 10 (Ru, Os, Rh, Ir, Pd, Pt) enthalten. Als Struktureinheiten für die Polymeren kommen hier z.B. verschiedene Komplexe in Frage, welche z.B. in der WO 02/068435, der WO 02/081488, der EP 1239526 und der WO 04/026886 beschrieben sind. Entsprechende Monomere werden in der WO 02/068435 und der WO 2005/042548 A1 beschrieben.

Bevorzugte Struktureinheiten der Gruppe 6 sind solche der folgenden Formeln: 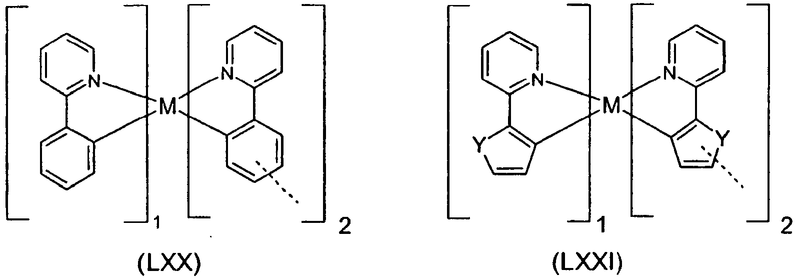 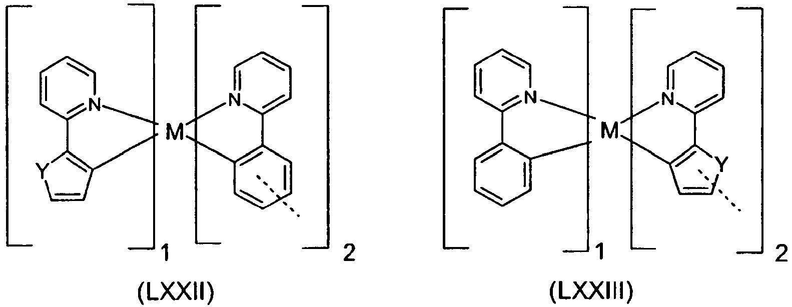 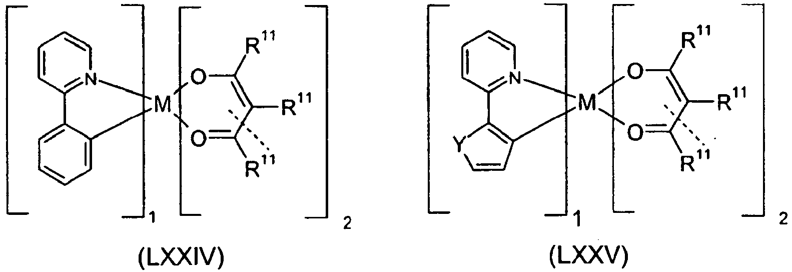 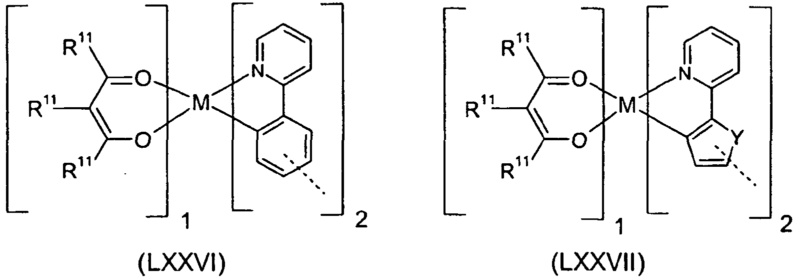 worin M für Rh oder Ir steht, Y die oben angegebene Bedeutung hat, und die verschiedenen Formeln an den freien Positionen durch eine oder mehrere Substituenten R¹¹ wie oben definiert substituiert sein können.

### Gruppe 7 - Struktureinheiten, welche den Übergang vom Singulett- zum Triplettzustand verbessern bzw. Verbindungen mit Fluorresten im Sinne der vorliegenden Erfindung, die diese Aufgabe erfüllen:

Dies sind insbesondere solche Struktureinheiten, welche den Übergang vom Singulett- zum Triplettzustand verbessern und welche, unterstützend zu den Strukturelementen der Gruppe 6 eingesetzt, die Phosphoreszenzeigenschaften dieser Strukturelemente verbessern. Hierfür kommen insbesondere Carbazol- und überbrückte Carbazoldimereinheiten in Frage, wie z.B. in der WO 04/070772 und der WO 04/113468 beschrieben. Weiterhin kommen hierfür Ketone, Phosphinoxide, Sulfoxide und ähnliche Verbindungen in Frage, wie z.B. in der WO 2005/040302 A1 beschrieben.

Es ist auch möglich, dass gleichzeitig mehr als eine Struktureinheit aus einer der Gruppen 1 bis 7 vorliegt.

Das Polymer kann weiterhin ebenfalls in die Haupt- oder Seitenkette gebundene Metallkomplexe enthalten, die im Allgemeinen aus einem oder mehreren Liganden und einem oder mehreren Metallzentren aufgebaut sind. Auch die Verbindungen mir Fluorresten können dieser Klasse entstammen.

Bevorzugt sind Polymere, die zusätzlich noch ein oder mehrere Struktureinheiten ausgewählt aus den Gruppen 1 bis 7 enthalten. Bevorzugt sind ferner fluorverbrückte Assoziate, die zusätzlich noch eine oder mehrere Struktureinheiten ausgewählt aus den Gruppen 1 bis 7 enthalten.

Ebenfalls bevorzugt ist es, wenn die Polymere oder das fluorverbrückte Assoziat Struktureinheiten enthalten, die den Ladungstransport und/oder die Ladungsinjektion verbessern, also Struktureinheiten aus Gruppe 2 und/oder 3; besonders bevorzugt ist ein Anteil von 1 bis 30 mol% dieser Struktureinheiten; ganz besonders bevorzugt ist ein Anteil von 2 bis 10 mol% dieser Struktureinheiten.

Besonders bevorzugt ist es weiterhin, wenn die Polymere oder das fluorverbrückte Assoziat Struktureinheiten aus Gruppe 1, Struktureinheiten aus Gruppe 2 und/oder 3 und Struktureinheiten aus Gruppe 5 enthalten.

Die Polymere weisen vorzugsweise 10 bis 10000, besonders bevorzugt 20 bis 5000 und insbesondere 50 bis 2000 Wiederholungseinheiten auf. Davon zu unterscheiden sind die erfindungsgemäßen fluorierten Oligomere, welche 3 bis 9 Wiederholungseinheiten aufweisen. Ansonsten können auch die Oligomere alle oben definierten Wiederholungseinheiten, auch die Emitter, besitzen.

Die nötige Löslichkeit der Polymere wird vor allem durch die Substituenten an den verschiedenen Wiederholungseinheiten gewährleistet.

Die Polymere können linear, verzweigt oder vernetzt sein. Die erfindungsgemäßen Copolymere können statistische, alternierende oder blockartige Strukturen aufweisen oder auch mehrere dieser Strukturen abwechselnd besitzen. Wie Copolymere mit blockartigen Strukturen erhalten werden können und welche weiteren Strukturelemente dafür besonders bevorzugt sind, ist beispielsweise ausführlich in der WO 2005/014688 beschrieben. Diese Schrift ist via Zitat Bestandteil der vorliegenden Anmeldung.

Die Polymere werden in der Regel durch Polymerisation von einer oder mehreren Monomersorten hergestellt. Geeignete Polymerisationsreaktionen sind dem Fachmann bekannt und in der Literatur beschrieben. Besonders geeignete und bevorzugte Polymerisations- und Kupplungsreaktionen, die alle zu C-C-Verknüpfungen führen, sind solche gemäß SUZUKI, YAMAMOTO, STILLE, HECK, NEGISHI, SONOGASHIRA oder HIYAMA.

Wie die Polymerisation nach diesen Methoden durchgeführt werden kann und wie die Polymere dann vom Reaktionsmedium abgetrennt und gereinigt werden können, ist dem Fachmann bekannt und in der Literatur, beispielsweise in der WO 2003/048225 und der WO 2004/037887 im Detail beschrieben.

Die C-C-Verknüpfungen sind vorzugsweise ausgewählt aus der Gruppe der SUZUKI-Kupplung, der YAMAMOTO-Kupplung und der STILLE-Kupplung.

Zur Synthese der Polymere werden die entsprechenden Monomere benötigt. Die Synthese von Struktureinheiten aus Gruppe 1 bis 7 ist dem Fachmann bekannt und in der Literatur, beispielsweise in der WO 2005/014689, beschrieben. Diese und die darin zitierte Literatur ist via Zitat Bestandteil der vorliegenden Anmeldung. Um die erfindungsgemäßen fluorierten Polymere zu erhalten kann ein entsprechendes Monomer mit einem fluorierten Monomer copolymerisiert werden.

Es kann außerdem bevorzugt sein, das Polymer nicht als Reinsubstanz, sondern als Mischung (Blend) zusammen mit weiteren beliebigen polymeren, oligomeren, dendritischen oder niedermolekularen Substanzen zu verwenden. Diese können beispielsweise die elektronischen Eigenschaften verbessern oder selber emittieren. Solche Blends sind daher auch Bestandteil der vorliegenden Erfindung.

Gegenstand der Erfindung sind weiterhin Lösungen und Formulierungen aus einem oder mehreren erfindungsgemäßen fluorverbrückten Assoziaten oder deren Vorstufen, d.h. fluorhaltige Polymere oder Blends und kleine Moleküle (fluoriert) und/oder Monomere (fluoriert), in einem oder mehreren Lösungsmitteln. Wie solche Lösungen hergestellt werden können, ist dem Fachmann bekannt und z.B. in der WO 02/072714, der WO 03/019694 und der darin zitierten Literatur beschrieben. Die Lösungen und Formulierungen können gegebenenfalls ein oder mehrere Additive enthalten.

Diese Lösungen können verwendet werden, z.B. in einem Verfahren, um dünne Schichten (oder Polymerschichten, oder Schichten kleiner Moleküle) des fluorverbrückten Assoziats herzustellen, zum Beispiel durch Flächenbeschichtungsverfahren (z. B. Spin-coating) oder durch Druckverfahren (z.B. InkJet Printing).

Ferner wird erfindungsgemäß eine optoelektronische Vorrichtung bereitgestellt, die eine Kathode, eine Anode und eine Schicht enthält, wobei die Schicht ein erfindungsgemäßes fluorverbrücktes Assoziat enthält.

Insbesondere ist die optoelektronische Vorrichtung, in der das fluorverbrückte Assoziat der vorliegenden Erfindung eingesetzt wird, erfindungsgemäß eine organische oder polymere Leuchtdiode, eine organische Solarzelle (O-SC, z. B. WO 98/48433, WO 94/05045), ein organischer Feldeffekt-Transistor (O-TFTs), ein organisches Schaltelement (O-IC, z. B. WO 95/31833, WO 99/10939), ein organisches Feld-Quench-Element (,FDQ, z. B. US 2004/017148), ein organischer optischer Verstärker, ein organischer Photorezeptor, eine organische Photodiode oder eine organische Laserdiode (O-LASER, z. B. WO 98/03566).

Die Vorrichtung wird in an sich bekannter Weise je nach Anwendung entsprechend strukturiert, kontaktiert und schließlich hermetisch versiegelt, da sich die Lebensdauer derartiger Vorrichtungen bei Anwesenheit von Wasser und/oder Luft drastisch verkürzt. Dabei kann es auch bevorzugt sein, als Elektrodenmaterial für eine oder beide der Elektroden (Elektrode und Gegenelektrode bzw. Anode und Kathode) ein leitfähiges, dotiertes Polymer zu verwenden und keine Zwischenschicht aus leitfähigem, dotiertem Polymer einzubringen.

Für Anwendungen in O-FETs und O-TFTs ist es außerdem erforderlich, dass der Aufbau außer der Elektrode und Gegenelektrode (source und drain) noch eine weitere Elektrode (gate) enthält, die durch eine Isolatorschicht mit einer in der Regel hohen (oder selten niedrigen) Dielektrizitätskonstante vom organischen Halbleiter abgetrennt ist. Außerdem kann es sinnvoll sein, in die Vorrichtung noch weitere Schichten einzubringen.

Die Elektroden werden im Sinne dieser Erfindung so gewählt, dass ihr Potential möglichst gut mit dem Potential der angrenzenden organischen Schicht übereinstimmt, um eine möglichst effiziente Elektronen- bzw. Lochinjektion zu gewährleisten.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielelektrizitätskonstante einzubringen. Hierfür kommen beispielsweise Alkalimetall- oder Erdalkalimetallfluoride, aber auch die entsprechenden Oxide in Frage (z. B. LiF, Li₂O, BaF₂, MgO, NaF, etc.). Die Schichtdicke dieser dielektrischen Schicht beträgt vorzugsweise zwischen 1 und 10 nm.

Als Anode sind Materialien mit hoher Austrittsarbeit bevorzugt. Vorzugsweise weist die Anode ein Potential größer 4,5 eV gegen Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau nutzt eine transparente Anode. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere.

Die Erfindung wird im Folgenden anhand von Ausführungsbeispielen, die nicht als beschränkend zu verstehen sind, näher erläutert.

### Ausführungsbeispiele

### Beispiele 1 und 2: Herstellung der Polymere

Das erfindungsgemäße Polymer P1 sowie das Vergleichspolymer V1 werden unter Verwendung der folgenden Monomere (Prozentangaben = mol%) durch SUZUKI-Kupplung gemäß der WO 03/048225 A2 synthetisiert.

### Beispiel 1 (Polymer P1)

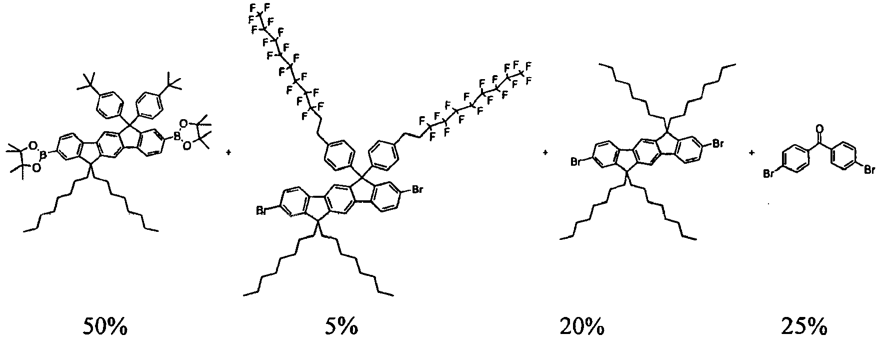

### Beispiel 2 (Polymer V1)

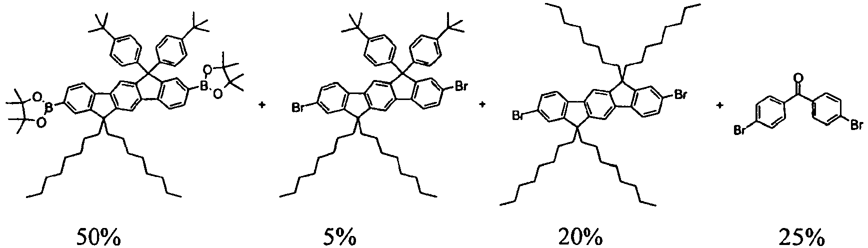

### Beispiele 3 und 4: Herstellung und Messung von emittierenden Schichten

In hochreinem, trockenem und sauerstofffreiem Toluol werden Lösungen der Polymere P1 und V1 mit den erfindungsgemäßen Emittern T1 und T2 erstellt. Die Konzentrationen betragen jeweils 8 Gew.-% des Emitters bezogen auf das Polymer, die Gesamteinwaage 12,5 mg/ml (i.e. 1 mg/ml T1 bzw. T2 und 11,5 mg/ml P1 bzw. V1). Durch Spincoaten auf Quarzobjektträger werden daraus Filme von 80 nm Schichtdicke erzeugt, die anschließend in einem PL-Spektrometer mit Stickstoff geflutetem Probenraum vermessen werden (Hitachi F-4500 Fluorescence Spectrometer). Ein Maß für die effiziente Übertragung von Anregungsenergie und damit auch eines durch Rekombination in einer OLED erzeugten Exzitons vom Polymer auf den Emitter ist das Verhältnis von Restemission des Polymers zur Emitteremission in einem solchen Film.

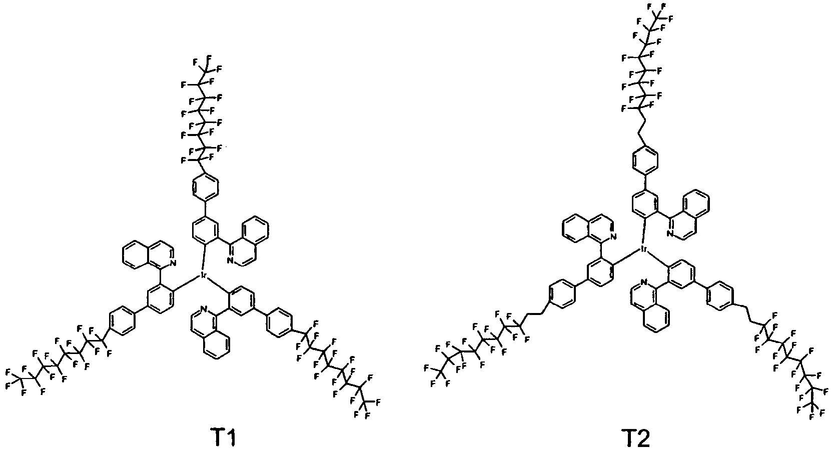

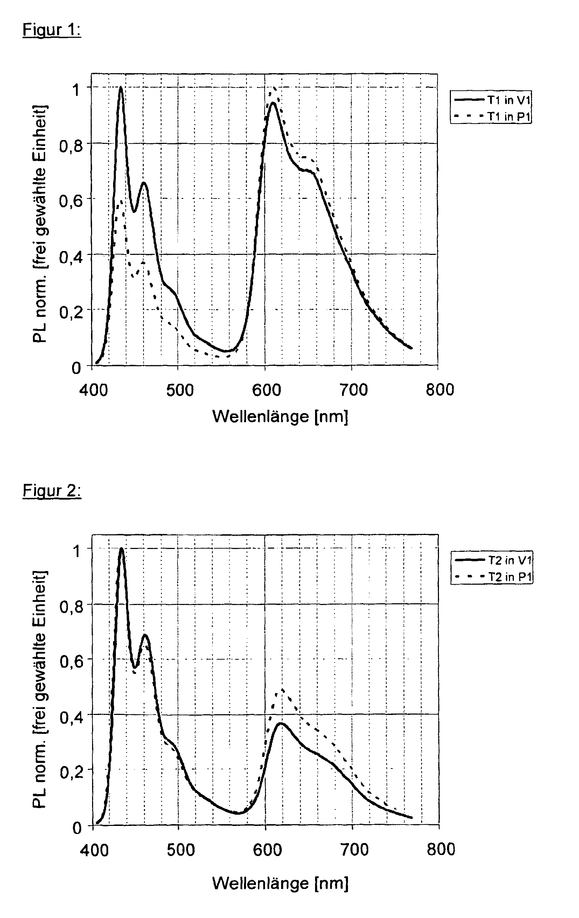

Figur 1 zeigt die Spektren von T1 in P1 und T1 in V1, Figur 2 die Spektren von T2 in P1 und T2 in V1. Die Anregungswellenlänge befindet sich jeweils im Absorptionsmaximum des Polymers bei 395 nm. In beiden Fällen zeigen die Spektren einen höheren Rotanteil für die ebenfalls fluorierte Matrix P1, die Übertragung der Anregungsenergie funktioniert also mit Hilfe der F-F-Wechselwirkung besser.

In Tabelle 1 sind die Ergebnisse zusammengefasst, die aus den normierten Spektren und der Einfachheit halber aus dem Verhältnis der Maxima errechnet werden.

**Tabelle 1:**

| Zusammensetzung | Verhältnis Rot / Blau | Rot / Blau |
|---|---|---|
| T1 in P1 | 1 : 0,6 | 1,67 |
| T1 in V1 | 0,95 : 1 | 0,95 |
| T2 in P1 | 0,48 : 1 | 0,48 |
| T2 in V1 | 0,37 : 1 | 0,37 |

## Patentansprüche

1. Fluorverbrücktes Assoziat, bestehend aus
• einem Oligomer oder Polymer, enthaltend Fluorreste, die an das Oligomer- oder Polymergrundgerüst gebunden sind, und
• einer Verbindung mit einem Fluorrest, **dadurch gekennzeichnet, dass** in dem Oligomer- oder Polymergrundgerüst eine Elektronentransport- und/oder Elektroneninjektionseinheit vorliegt, ausgewählt aus substituierten oder unsubstituierten Pyridinen, Pyrimidinen, Pyridazinen, Pyrazinen, Pyrenen, Perylenen, Anthracenen, Benzanthracenen, Oxadiazolen, Chinolinen, Chinoxalinen, Phenazinen, Benzimidazolen, Ketonen, Phosphinoxiden, Sulfoxiden, Triazinen, Triarylboranen und Benzophenonen,
dass das fluorverbrückte Assoziat eine Emittereinheit als Verbindung mit einem Fluorrest umfasst,
dass die Emittereinheit ein Triplett-Emitter ist, der Ru, Os, Rh, Ir, Pd oder Pt enthält und
dass die Fluorreste die allgemeine Formel CₓH_{y}F_{z} haben, wobei x > 0, y ≥ 0 und z ≥ 1 sind und keine, eine oder mehrere CH₂-Gruppen, die auch benachbart sein können, durch O, S, Se, Te, Si(R¹)₂, Ge(R¹)₂, NR¹, PR¹, CO, P(R¹)O ersetzt sein können, wobei R¹ bei jedem Auftreten gleich oder verschieden eine geradkettige, verzweigte oder cyclische Alkyl-, Alkenyl-, Alkinyl-, Aryl-, Arylalkyl-, Arylalkenyl-, Arylalkinyl-, Heteroaryl- oder Heteroalkylgruppe ist, wobei auch ein oder mehrere nicht benachbarte C-Atome der nicht aromatischen Anteile durch O, S, COO, OCO ersetzt sein können, mit der Maßgabe, dass zwei Reste R¹ auch miteinander Ringsysteme bilden können.

2. Fluorverbrücktes Assoziat nach Anspruch 1, **dadurch gekennzeichnet, dass** das Oligomer oder das Polymer ein nicht-konjugiertes, ein teilkonjugiertes oder ein konjugiertes Homo- oder Co-Oligomer oder -Polymer ist.

3. Fluorverbrücktes Assoziat nach Anspruch 1 oder 2, **dadurch gekennzeichnet, dass** in dem Oligomer oder Polymer zwischen dem Oligomer- oder Polymergrundgerüst und den Fluorresten ein Spacer vorliegt.

4. Formulierung, enthaltend ein fluorverbrücktes Assoziat nach einem oder mehreren der Ansprüche 1 bis 3 oder eine Vorstufe davon zusammen mit einem oder mehreren Lösungsmitteln.

5. Optoelektronische Vorrichtung, enthaltend eine Kathode, eine Anode und eine Schicht, enthaltend ein fluorverbrücktes Assoziat nach einem oder mehreren der Ansprüche 1 bis 3.

6. Optoelektronische Vorrichtung nach Anspruch 5, **dadurch gekennzeichnet, dass** die optoelektronische Vorrichtung eine organische oder polymere Leuchtdiode, eine organische Solarzelle, ein organischer Feldeffekttransistor, ein organischer Dünnfilmtransistor, ein organisches Schaltelement, ein organisches Feld-Quench-Element, ein organischer optischer Verstärker, ein organischer Photorezeptor, eine organische Photodiode oder eine organische Laserdiode ist.

## Claims

1. Fluorine-bridged associate consisting of
• an oligomer or polymer containing fluorine radicals which are bonded to the oligomer or polymer backbone, and
• a compound containing a fluorine radical,
**characterised in that** the oligomer or polymer backbone contains an electron-transport and/or electron-injection unit selected from substituted or unsubstituted pyridines, pyrimidines, pyridazines, pyrazines, pyrenes, perylenes, anthracenes, benzanthracenes, oxadiazoles, quinolines, quinoxalines, phenazines, benzimidazoles, ketones, phosphine oxides, sulfoxides, triazines, triarylboranes and benzophenones,
**in that** the fluorine-bridged associate includes an emitter unit as compound containing a fluorine radical,
**in that** the emitter unit is a triplet emitter which contains Ru, Os, Rh, Ir, Pd or Pt and
**in that** the fluorine radicals have the general formula CₓH_{y}F_{z}, where x > 0, y ≥ 0 and z ≥ 1, and no, one or more CH₂ groups, which may also be adjacent, may be replaced by O, S, Se, Te, Si(R¹)₂, Ge(R¹)₂, NR¹, PR¹, CO, P(R¹)O, where R¹ is on each occurrence, identically or differently, a straight-chain, branched or cyclic alkyl, alkenyl, alkynyl, aryl, arylalkyl, arylalkenyl, arylalkynyl, heteroaryl or heteroalkyl group, where, in addition, one or more non-adjacent C atoms in the nonaromatic moieties may be replaced by O, S, COO, OCO, with the proviso that two radicals R¹ may also form ring systems with one another.

2. Fluorine-bridged associate according to Claim 1, **characterised in that** the oligomer or polymer is a non-conjugated, partially conjugated or conjugated homo- or co-oligomer or -polymer.

3. Fluorine-bridged associate according to Claim 1 or 2, **characterised in that** the oligomer or polymer contains a spacer between the oligomer or polymer backbone and the fluorine radicals.

4. Formulation comprising a fluorine-bridged associate according to one or more of Claims 1 to 3 or a precursor thereof together with one or more solvents.

5. Opto-electronic device comprising a cathode, an anode and a layer comprising a fluorine-bridged associate according to one or more of Claims 1 to 3.

6. Opto-electronic device according to Claim 5, **characterised in that** the opto-electronic device is an organic or polymeric light-emitting diode, an organic solar cell, an organic field-effect transistor, an organic thin-film transistor, an organic integrated circuit, an organic field-quench element, an organic optical amplifier, an organic photoreceptor, an organic photodiode or an organic laser diode.

## Revendications

1. Associé ponté par fluor constitué par :
• un oligomère ou polymère contenant des radicaux fluor qui sont liés à l'ossature d'oligomère ou de polymère, et
• un composé contenant un radical fluor,
**caractérisé en ce que** :
l'ossature d'oligomère ou de polymère contient une unité de transport d'électrons et/ou d'injection d'électrons choisie parmi les pyridines, les pyrimidines, les pyridazines, les pyrazines, les pyrènes, les pérylènes, les anthracènes, les benzanthracènes, les oxadiazoles, les quinolines, les quinoxalines, les phénazines, les benzimidazoles, les cétones, les oxydes de phosphine, les sulfoxydes, les triazines, les triarylboranes et les benzophénones substitués ou non substitués,
l'associé ponté par fluor inclut une unité d'émetteur en tant que composé contenant un radical fluor,
l'unité d'émetteur est un émetteur de triplet qui contient Ru, Os, Rh, Ir, Pd ou Pt et
les radicaux fluor présentent la formule générale CₓH_{y}F_{z}, où x > 0, y ≥ 0 et z ≥ 1, et aucun groupe CH₂, lesquels groupes peuvent également être adjacents, ne peut être remplacé par O, S, Se, Te, Si(R¹)₂, Ge(R¹)₂, NR¹, PR¹, CO, P(R¹)O ou un ou plusieurs groupes CH₂ peut/peuvent être ainsi remplacé(s), où R¹ est, pour chaque occurrence, de manière identique ou différente, un groupe alkyle, alkényle, alkynyle, aryle, arylalkyle, arylalkényle, arylalkynyle, hétéroaryle ou hétéroalkyle en chaîne droite, ramifié ou cyclique, où, en outre, un ou plusieurs atomes de C non adjacents dans les moitiés non aromatiques peut/peuvent être remplacé(s) par O, S, COO, OCO, étant entendu que deux radicaux R¹ peuvent également former des systèmes de cycle l'un avec l'autre.

2. Associé ponté par fluor selon la revendication 1, **caractérisé en ce que** l'oligomère ou le polymère est un homo- ou co-oligomère ou -polymère non conjugué, partiellement conjugué ou conjugué.

3. Associé ponté par fluor selon la revendication 1 ou 2, **caractérisé en ce que** l'oligomère ou le polymère contient un espaceur entre l'ossature d'oligomère ou de polymère et les radicaux fluor.

4. Formulation comprenant un associé ponté par fluor selon une ou plusieurs des revendications 1 à 3 ou son précurseur en association avec un ou plusieurs solvants.

5. Dispositif opto-électronique comprenant une cathode, une anode et une couche comprenant un associé ponté par fluor selon une ou plusieurs des revendications 1 à 3.

6. Dispositif opto-électronique selon la revendication 5, **caractérisé en ce que** le dispositif opto-électronique est une diode émettrice de lumière organique ou polymérique, une cellule solaire organique, un transistor à effet de champ organique, un transistor à film mince organique, un circuit intégré organique, un élément à extinction de champ organique, un amplificateur optique organique, un photorécepteur organique, une photodiode organique ou une diode laser organique.
